**Europäisches Patentamt**

**European Patent Office**

**Office européen des brevets**

(11) Veröffentlichungsnummer: **0 062 307**
**B1**

(12) # EUROPÄISCHE PATENTSCHRIFT

(45) Veröffentlichungstag der Patentschrift:
26.02.86

(51) Int. Cl.⁴: **H 01 H 50/14,** H 01 H 50/04

(21) Anmeldenummer: **82102760.4**

(22) Anmeldetag: **01.04.82**

(54) Elektromagnetisches Relais.

(30) Priorität: **04.04.81 DE 3113635**

(43) Veröffentlichungstag der Anmeldung:
**13.10.82 Patentblatt 82/41**

(45) Bekanntmachung des Hinweises auf die Patenterteilung:
**26.02.86 Patentblatt 86/9**

(84) Benannte Vertragsstaaten:
**AT DE FR GB SE**

(56) Entgegenhaltungen:
**DE - A - 2 428 109**
**FR - A - 1 129 730**
**GB - A - 1 321 174**
**US - A - 3 618 136**
**US - A - 4 254 391**

(73) Patentinhaber: **Hermann Stribel KG, Benzstrasse,
D-7443 Frickenhausen (DE)**

(72) Erfinder: **Kröner, Otwin, Mörikestrasse 12,
D-7317 Wendlingen (DE)**

LIBER, STOCKHOLM 1986

## Beschreibung

Die Erfindung betrifft ein elektromagnetisches Relais mit einem Joch, das mindestens einen Schenkel aufweist, der an einer seiner freien Außenkanten mindestens einen in ein Loch einer Printplatte einsetzbaren Befestigungszapfen aufweist, und mit einer Erregerspule, deren Spulenkörper über den Spulenkern am Schenkel des Jochs befestigt ist, mit einem Spulenflansch am Schenkel anliegt und mindestens einen feststehenden Kontakt mit einem Kontaktanschlußstift sowie Spulenanschluß-stifte aufweist, die sich quer zur Längsachse des Spulenkerns erstrecken und ebenfalls in Löcher der Printplatte einsetzbar sind; und mit einem am Joch angelenkten, federbelasteten, mindestens einen beweglichen Kontakt tragenden Anker.

Ein bekanntes Relais dieser Art kann nur in einer einzigen Position an der Printplatte befestigt werden, so daß die Einsatzmöglichkeit begrenzt ist. Bei unterschiedlichen Montagepositionen muß also stets eine separate Relaisausführungsform erstellt werden, wodurch die Herstellung und Lagerhaltung kostenaufwendig wird.

Die Aufgabe der Erfindung besteht demgemäß darin, ein Relais der eingangs genannten Art so zu gestalten, daß es ohne zusätzliche Teile in verschiedenen Positionen montiert werden kann, so daß eine rationelle Herstellung sowie Teilelagerung möglich ist.

Diese Aufgabe wird erfindungsgemäß dadurch gelöst, daß das Joch an mindestens einer weiteren seiner freien Außenkanten mindestens einen sich quer zur Längsachse des Kerns, jedoch im wesentlichen rechtwinklig zum ersten Befestigungszapfen erstreckenden zweiten Befestigungszapfen aufweist und daß der Spulenkörper zur wahlweisen Parallelausrichtung der Kontaktanschlußstifte sowie der Spulenanschlußstifte mit dem/den ersten Befestigungszapfen oder dem/den zweiten Befestigungszapfen um etwa 90 Grad um die Längsachse des Kerns drehversetzbar am Joch angeordnet ist.

Vorteilhafte Weiterbildungen und Ausgestaltungen der Erfindung sind durch die Merkmale der Unteransprüche gekennzeichnet, wobei es insbesondere günstig sein kann, an allen freien Außenkanten des einen Schenkels des bevorzugt L-förmig ausgebildeten Jochbügels je zwei parallele Befestigungszapfen anzuordnen, so daß die Möglichkeit besteht, den Spulenkörper je nach Bedarf so zu positionieren, daß das Relais in drei verschiedenen Seitenlagen verwendet werden kann. Dabei ist es auch möglich, das Relais durch eine entsprechende Schaltungsausführung an der Printplatte nicht als Schaltelement, sondern als Summer zu betreiben, was gerade bei einer Randseitenmontage mit nur einer Schaltkontaktgabe günstig sein kann. Für eine rationelle Printplattenbestückung kann es darüber hinaus auch besonders vorteilhaft sein, die printplattenseitigen Befestigungszapfen, die Spulenanschlußstifte und die Kontaktanschluß-stifte in zwei parallelen Reihen in Richtung der Längsachse des Kerns hintereinander anzuordnen und insbesondere hierbei die Befestigungszapfen, die Spulenanschlußstifte und die Kontaktanschluß-stifte in einem solchen Abstand zueinander zu positionieren, daß eine gleichmäßige Rastermaß-teilung gegeben ist. Dadurch kann ohne weiteres auf gängige Printplatten mit einer Einheitsrasterlochung zurückgegriffen werden, wodurch eine ausgesprochen rationelle und kostengünstige Herstellung möglich ist.

Darüber hinaus kann es zur Verdrehsicherung des Spulenkörpers insbesondere zweckmäßig sein, einen Flansch des Spulenkörpers so auszuführen, daß mindestens zwei zueinander rechtwinklig verlaufende Schmalseiten gegeben sind, die einen gleichen Abstand zur Längsachse des Kerns besitzen und von denen eine an einer Schenkelinnenfläche des Jochs anliegt, wobei es besonders vorteilhaft sein kann, den Flansch des Spulenkörpers rechteckförmig zu gestalten.

Weiterhin kann es gunstig sein, den Spulenkorper mit einem U-Teil zu versehen und an diesem sowohl zwei Ruhekontakte als auch zwei Arbeitskontakte anzuordnen, wobei zwischen diesen Kontakten an einem Kontaktfederblech des Ankers zwei Schaltkontakte gelagert sind. Es ist somit bei einer äußerst kleinen Relaisausführung eine ausgesprochen hohe Stromschaltfähigkeit gegeben, indem durch Parallelschaltung der Kontakte eine Verdoppelung der Stromschaltfähigkeit möglich ist, so daß bei einer Einzelkontaktbenutzung eine Stromschaltfähigkeit bis zu ca. 20 A und bei einer Parallelschaltung der Kontakte eine Stromschaltfähigkeit bis zu etwa 40 A zur Verfügung steht. Die Spulen-anschlußstifte können zweckmäßig über Verlängerungsstege am U-Teil des Spulenkörpers befestigt sein, wobei die Verlängerungsstege im Mittenbereich des U-Teils zwischen zwei Kontaktanschlußstiften angeordnet sein können. Die Spulenanschlußstifte selbst befinden sich dabei vorteilhaft ungefähr im Mittenbereich unter der Spule.

Ein Ausführungsbeispiel der Erfindung wird nachstehend anhand der Zeichnung beschrieben. Es stellt dar:

FIG. 1 eine stark vergrößerte Vorderansicht eines erfindungsgemäßen Relais,

FIG. 2 eine weitere Vorderansicht des Relais der FIG. 1, jedoch in einer um 90° geschwenkten Position,

FIG. 3 eine Seitenansicht des Relais der FIG. 1, jedoch in einer etwas geringeren Vergrößerung,

FIG. 4 eine Rückansicht des Relais der FIG. 3,

FIG. 5 eine Draufsicht auf das Relais der FIG. 3 und

FIG. 6 eine Unteransicht des Relais der FIG. 3.

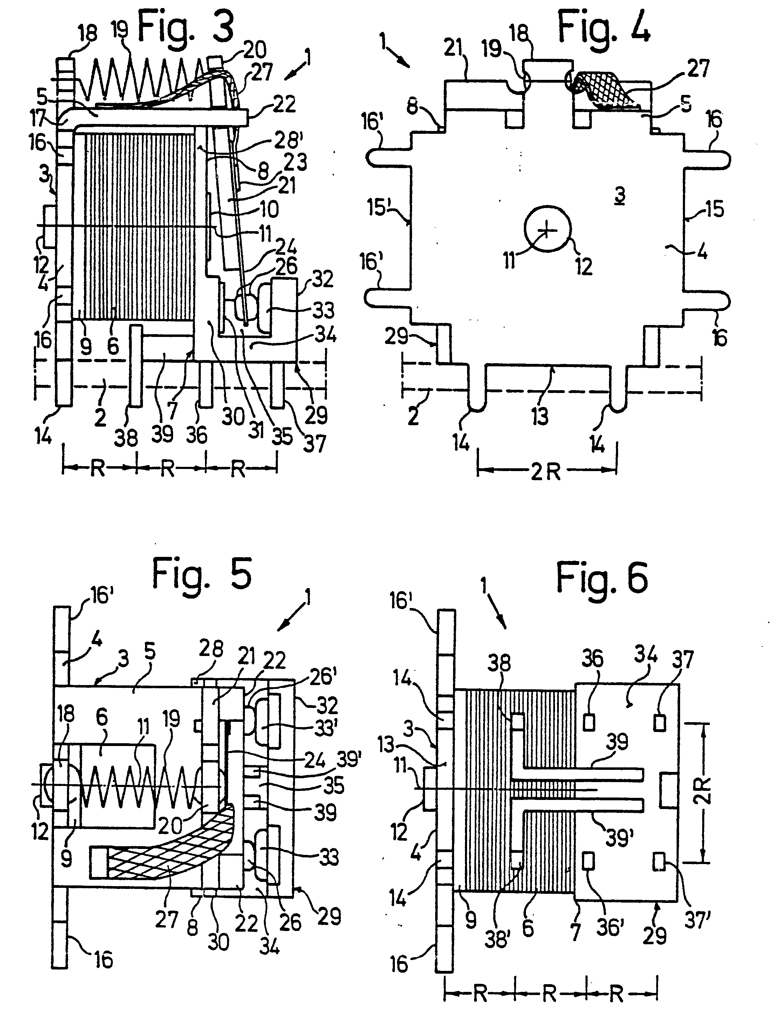

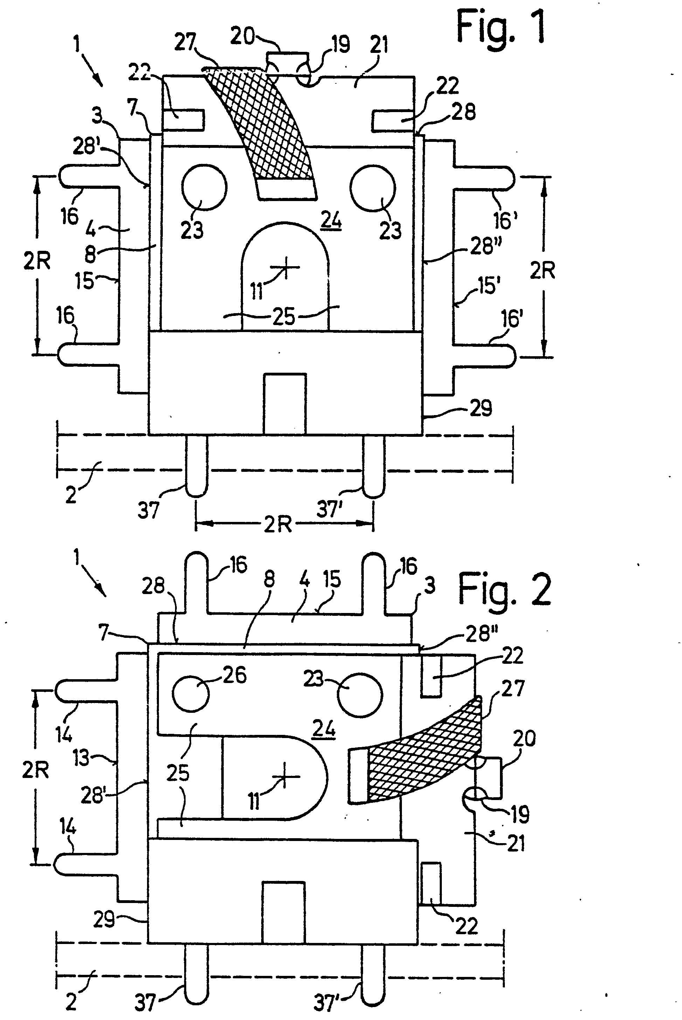

Das in den FIG. 1 bis 6 dargestellte Relais 1 ist für eine Befestigung an einer Printplatte 2 vorgesehen, die in der Zeichnung gestrichelt angedeutet worden ist und an ihrer Unterseite üblicherweise Leiterbahnen aufweist. Das Relais 1 besitzt ein als L-förmigen Bügel ausgeführtes Joch 3, das einen ersten Schenkel 4 sowie einen zweiten Schenkel 5 aufweist. Im Winkelbereich des Jochs 3 befindet sich eine Spule 6, die auf einem aus Isolierstoff gebildeten Spulenkörper 7 gelagert ist. Der Spulenkörper 7 besitzt eine Stirnplatte 8 und eine Rückplatte 9, die die Spule 6 stirnseitig begrenzen. Ein Kern 10, dessen Längsachse 11 parallel zum Schenkel 5 des Jochs 3 verläuft, durchsetzt den Spulenkörper 7 und ist am ersten Schenkel 4 des Jochs 3 mittels eines Nietansatzes 12 befestigt.

Der Schenkel 4 des Jochs 3 besitzt an der unteren Außenkante 13 zwei zueinander auf Abstand angeordnete parallele Befestigungszapfen 14, die in Löcher der Printplatte 2 einsteckbar und an den herausragenden freien Endbereichen zum Beispiel durch Löten, Nieten, Spreizen oder dergleichen festlegbar sind. Darüber hinaus befinden sich auch an den beiden angrenzenden Außenkanten 15, 15' des rechteckigen Schenkels 4 des Jochs 3 je zwei weitere zweite Befestigungszapfen 16, 16', die im wesentlichen wie die ersten Befestigungszapfen 14 ausgeführt sind, sich jedoch in der Ebene des Schenkels 4 rechtwinklig zu den ersten Befestigungszapfen 14 erstrecken. Alle Befestigungszapfen 14, 16, 16' sind einstückig mit dem Schenkel 4 des Jochs 3 und aus demselben Material ausgeführt und werden bei der Herstellung des Jochs 3 in einem einzigen Arbeitsgang mit ausgebildet.

Am äußeren Winkeleck 17 des Jochs 3 ist in Verlängerung des Schenkels 4 ein vorstehender Zapfenteil 18 ausgebildet, an dem ein Ende einer Schraubenzugfeder 19 festgelegt ist. Das andere Ende der sich über den Schenkel 5 parallel zur Längsachse 11 erstreckenden Schraubenzugfeder 19 ist an einem Vorsprung 20 befestigt, der im wesentlichen wie der Zapfenteil 18 gestaltet ist und an einem als rechteckige Platte ausgebildeten Anker 21 angeordnet ist.

Der Anker 21 ist an zwei Stegteilen 22 des Schenkels 5 klappbar gelagert und liegt vor der Ebene der Stirnplatte 8 des Spulenkörpers 7. An der Vorderfläche des Ankers 21 ist mittels Prägenieten 23 ein dünnes Kontaktfederblech 24 befestigt, das an zwei freien Schenkelteilen 25 je einen doppelseitigen Schaltkontakt 26, 26' aufweist. Am Anker 21 ist im Bereich zwischen den Prägenieten 23 außerdem eine Metallitze 27 befestigt, die anderenends auf der Oberseite des Schenkels 5 festgelegt ist.

Der Flansch 8 des Spulenkörpers 7 ist als Rechteckplatte ausgeführt und besitzt daher drei zueinander rechtwinklig verlaufende Schmalseiten 28, 28', 28'', die alle in gleichem Abstand zu Längsachse 11 des Kerns 10 angeordnet sind. Der Abstand der Schmalseiten 28, 28', 28'' zur Längsachse 11 ist so bemessen, daß er nur geringfügig kleiner ist als der Abstand zwischen der Längsachse 11 und der Innenfläche des Schenkels 5, so daß durch die Anlage einer der Schmalseiten 28, 28', 28'' am Schenkel 5 auf einfache Art und Weise eine verdrehsichernde Arretierung des Spulenkörpers 7 am Joch 3 gegeben ist.

Der Spulenkörper 7 weist zudem ein einstückig angeformtes U-Teil 29 auf, dessen einer Seitenteil 30 zwei Arbeitskontakte 31, 31' besitzt, während der zum Seitenteil 30 auf Abstand parallel verlaufende Freischenkel 32 des U-Teils 29 zwei Ruhekontakte 33, 33' trägt, an denen die Schaltkontakte 26, 26' des Ankers 21 bei nicht eingeschaltetem Magnetfeld aufgrund der Kraft der Schraubenzugfeder 19 anliegen. Der Seitenteil 30 und der Freischenkel 32 sind durch einen Unterschenkel 34 verbunden, der der Anlage an der Printplatte 2 dient. Der U-Teil 29 besitzt in seinem Mittenbereich zwischen den beiden Schenkelteilen 25 des Kontaktfederblechs 24 einen Quersteg 35, der den Seitenteil 30 und den Freischenkel 32 miteinander verbindet.

An der der Printplatte 2 zugewandten Anlagefläche des Unterschenkels 34 ragen zwei den Arbeitskontakten 31, 31' zugehörige Kontaktanschlußstifte 36, 36' sowie zwei den Ruhekontakten 33, 33' zugehörige weitere Kontaktanschlußstifte 37, 37' hervor. Außerdem befinden sich etwa in der Mitte unter der Spule 6 des Relais 1 im Bereich zwischen den Befestigungszapfen 14 (FIG. 3) des Jochs 3 und den Kontaktanschlußstiften 36, 36' des Spulenkörpers 7 zwei Spulenanschlußstifte 38, 38'. Diesen beiden Spulenanschlußstiften 38, 38' sind rechtwinklig abstrebende, winkelförmige Verlängerungsstege 39, 39' zugeordnet, die zwischen den beiden Kontakt-anschlußstiften 36, 36' im Bereich des Querstegs 35 am Unterschenkel 34 des U-Teils 29 festgelegt sind.

Wie insbesondere den FIG. 3 und 6 zu entnehmen ist, sind die printplattenseitigen Befestigungszapfen 14, die Spulenanschlußstifte 38, 38' und die Kontaktanschlußstifte 36, 36' und 37, 37' in Richtung der Längsachse 11 gesehen in zwei parallelen Reihen hintereinander angeordnet. Die Abstände zwischen den Befestigungszapfen 14, den Spulenanschlußstiften 38, 38' und den Kontaktanschlußstiften 36, 36', 37, 37' sind dabei so bemessen, daß sie einer Rastermaßteilung R entsprechen, die gleich einer Rastermaßteilung der Löcher in der Printplatte 2 ist, so daß unter Einsparung zusätzlicher Lochungsarbeiten jederzeit eine problemlose Steckmontage des Relais 1 gewährleistet ist. Beim vorliegenden Ausführungsbeispiel ist der Abstand zwischen den beiden Befestigungszapfen 14 sowie den Anschlüssen in Richtung quer zur Längsachse 11 doppelt so groß wie der Abstand in Richtung parallel zur Längsachse 11 ausgeführt und beträgt somit 2R.

Insbesondere den FIG. 1 und 2 ist zu entnehmen, daß das erfindungsgemäße Relais 1 in verschiedenen Lagen verwendet werden kann, wodurch eine vielseitige Einsatzmöglichkeit erreicht wird. Während bei der FIG. 1 die die Außenkante 13 des ersten Schenkels des dem Seitenrand 13 des Jochs 3 zugehörigen Befestigungszapfen 14 in die Printplatte 2 eingesteckt sind, befinden sich bei der Darstellung in FIG. 2 die der Außenkante 15' des Jochs 3 zugehörigen Befestigungszapfen 16' in der Printplatte 2. Dazu ist der Spulenkörper 7 gegenüber der Anordnung in FIG. 1 um die Längsachse 11 des Kerns 10 um 90° gedreht worden, so daß nunmehr die Kontaktanschlußstifte 36, 36', 37, 37' sowie die Spulen-anschlußstifte 38, 38' mit den Befestigungszapfen 16' der einen Randseite 15' parallel zueinander verlaufen. Die Befestigungszapfen 14 des Jochs 3 streben somit in der FIG. 2 seitlich ab und der Vorsprung 20 mit der Schraubenzugfeder 19 liegt an der anderen Seite. Ebenso ist es möglich, das Relais 1 in einer dritten Position zu verwenden, indem durch eine entsprechende Verdrehung des Spulenkörpers 7 um die Längsachse 11 eine solche Ausrichtung der Befestigungszapfen 16 zu den Kontaktanschlußstiften 36, 36', 37, 37' und den Spulenanschlußstiften 38, 38' vorgenommen wird, daß sie in die Printplatte 2 eingesteckt werden können. In einem solchen Falle würde dann das Relais 1 gegenüber der Darstellung in FIG. 2 im Gegenuhrzeigersinn um 180° gewendet sein. Dabei ist in jedem Falle eine Verdrehsicherung des Spulenkörpers 7 gegenüber dem Joch 3 durch die Anlage jeweils einer entsprechenden Schmalseite 28, 28', 28'' der Stirnplatte 8 am Schenkel 5 gegeben. Durch die vielseitige Montagemöglichkeit des Relais 1 wird eine nicht unerhebliche Kosteneinsparung erzielt und es ist praktisch ohne Mehraufwand möglich, das Relais 1 für unterschiedliche Einsatzzwecke gerade auch bei beengten Platzverhältnissen auf der Printplatte 2 vorzusehen, wobei es insbesondere bei einer Anordnung gemäß der FIG. 2 auch möglich ist, das Relais 1 bei entsprechender Kontaktschaltung als Summer zu betreiben, so daß zum einen ein Relais 1 mit ausgesprochen kleinen Abmessungen und sehr hoher Stromschaltfähigkeit zur Verfügung steht, das in unterschiedlichen Lagen platzsparend positioniert werden kann und zudem auch als Summer verwendbar ist. Bei einem Einsatz als Summer kann es zum Beispiel zur Erzielung einer anderen Summertonfrequenz vorteilhaft sein, das Kontaktfederblech 24 in Stahl auszuführen. Sofern bei einer solchen Ausführung während des Betriebs größere Kräfte zu überwinden sind, wäre die Schraubenzugfeder 19 entsprechend stärker auszulegen.

Eine weitere Vereinfachung und vorteilhafte Variante kann bei dem als Massenartikel zu bezeichnenden Relais 1 dadurch erreicht werden, daß eine Schraubenzugfeder 19 verwendet wird, die aus Beryllium besteht. Dadurch besitzt die Feder nicht nur eine ausgesprochen zuverlässige Dauerfederkraft, sondern auch eine gute und gegenüber einer Stahlfeder wesentlich bessere Leitfähigkeit, so daß insgesamt zum einen über die Klapplagerung des Ankers 21 an den Stegteilen 22 des Jochs 3 und zum anderen über die Beryllium-Schraubenzugfeder 19, die einenends am Zapfenteil 18 und anderenends am Vorsprung 20 unter Dauervorspannung kontaktierend befestigt ist, auf einfache Art und Weise unter Aufrechterhaltung einer guten Stromschaltfähigkeit eine sichere Verbindung gegeben ist. Es ist deshalb möglich, das Relais 1 auch ohne Metallitze 27 auszuführen, wodurch die Herstellung vereinfacht und eine kostengünstige Ausführung erreicht wird, da die verhältnismäßg teure Metallitze 27 hierbei vollständig entfällt und somit auch deren kostenaufwendige Schweiß-kontaktierung am Joch 3 sowie am Anker 21 eingespart wird.

**Patentansprüche:**

1. Elektromagnetisches Relais mit einem Joch (3), das mindestens einen Schenkel (4) aufweist, der an einer (13) seiner freien Außenkanten mindestens einen in ein Loch einer Printplatte (2) einsetzbaren Befestigungszapfen (14) aufweist, und mit einer Erregerspule (6) deren Spulenkörper (7) über den Spulenkern (10) am Schenkel (4) des Jochs (3) befestigt ist, mit einem Spulenflansch (9) am Schenkel (4) anliegt und mindestens einen feststehenden Kontakt (31,33) mit einem Kontaktanschlußstift (36, 37) sowie Spulenanschlußstifte (38) aufweist, die sich quer zur Längsachse des Spulenkerns (10) erstrecken und ebenfalls in Löcher der Printplatte (2) einsetzbar sind; und mit einem am Joch (3) angelenkten, federbelasteten, mindestens einen beweglichen Kontakt (26) tragenden Anker (21), dadurch gekennzeichnet, daß das Joch (3) an mindestens einer weiteren (15, 15,) seiner freien Außenkanten mindestens einen sich quer zur Längsachse (11) des Kerns (10), jedoch im wesentlichen rechtwinklig zum ersten Befestigungszapfen (14) erstreckenden zweiten Befestigungszapfen (16, 16') aufweist und daß der Spulenkörper (7) zur wahlweisen Parallelausrichtung der Kontaktanschlußstifte (36, 36', 37, 37') sowie der Spulenanschluß-stifte (38, 38') mit dem/den ersten Befestigungszapfen (14) oder dem/den zweiten Befestigungszapfen (16, 16') um etwa 90° um die Längsachse (11) des Kerns (10) drehversetzbar am Joch (3) angeordnet ist.

2. Relais nach Anspruch 1, dadurch gekennzeichnet, daß an allen freien Außenkanten (13, 15, 15') des Schenkels (4) des Jochs (3) je zwei parallele Befestigungszapfen (14, 16, 16') angeordnet sind.

3. Relais nach einem der vorstehenden Ansprüche, dadurch gekennzeichnet, daß die Befestigungszapfen (14, 16, 16'), die Spulenanschlußstifte (38, 38') und Kontaktanschlußstifte (36, 36', 37, 37') in in Richtung der Längsachse (11) dea Kerns (10) verlaufenden parallelen Reihen zur Printplatte (2) hin angeordnet sind.

4. Relais nach einem der vorstehenden Ansprüche, dadurch gekennzeichnet, daß die Befestigungszapfen (14, 16, 16'), die Spulenanschlußstifte (38, 38') und die Kontaktanschlußstifte (36, 36', 37 37') gemäß einer Rasterteilung (R) zueinander auf Abstand angeordnet sind.

5. Relais nach einem der vorstehenden Ansprüche, dadurch gekennzeichnet, daß ein Flansch (8) des Spulenkörpers (7) mindestens zwei zueinander rechtwinklig verlaufende Schmalseiten (28, 28', 28'') aufweist, deren Abstand zur Längsachse (11) des Kerns (10) gleich ist und von denen eine verdrehsichernd dicht neben dem zweiten Schenkel (5) des Jochs (3) angeordnet ist.

6. Relais nach einem der vorstehenden Ansprüche, dadurch gekennzeichnet, daß an einem U-Teil (29) des Spulenkörpers (7) zwei Ruhekontakte (33, 33') und zwei Arbeitskontakte (31, 31') angeordnet sind und daß zwischen den Ruhekontakten (33, 33') und den Arbeitskontakten (31, 31') zwei an einem Kontaktfederblech (24) des Ankers (21) befestigte Schaltkontakte (26, 26') gelagert sind.

7. Relais nach einem der vorstehenden Ansprüche, dadurch gekennzeichnet, daß die Spulenanschlußstifte (38, 38') über Verlängerungsstege (39, 39') im Mittenbereich des U-Teils (29) des Spulenkörpers (7) zwischen zwei Kontaktanschlußstiften (36, 36') befestigt sind.

8. Relais nach einem der vorstehenden Ansprüche, dadurch gekennzeichnet, daß die Spulenanschlußstifte (38, 38') unter der Spule (6) etwa in deren Längsmittenbereich zwischen den Befestigungszapfen (14, 16, 16') des Jochs (3) und den Kontaktanschlußstiften (36, 36') des Spulenkörpers (7) angeordnet sind.

9. Relais nach einem der vorstehenden Ansprüche, dadurch gekennzeichnet, daß außerhalb des drehversetzbaren Spulenkörpers (7) unter Vorspannung zwischen einem Zapfenteil (18) des Jochs (3) und einem Vorsprung (20) des Ankers (21) eine aus Beryllium hergestellte Schraubenzugfeder (19) angeordnet ist.

**Claims**

1. Electromagnetic relay comprising a yoke (3) which possesses at least one arm (4) which arm possesses, at one (13) of its free outer edges, at least one fixing pin (14) capable of being inserted into a hole of a printed circuit board (2), and comprising an excitation coil (8), the coil body (?) of which is fixed via the coil core (10) to the arm (4) of the yoke (3) and bears with a coil flange (9) against the arm (4) and oomprises at least one stationary contact (31, 33) having a oontact terminal pin (36, 37) and also coil terminal pins (38), which extend tränsversely to the longitudinal axis of the coil core (10) and likewise can be inserted into holes of the printed circuit board (2), and comprising a spring-loaded armature (21), articulated to the yoke (3) and carrying at least one movable contact (26), characterized in that the yoke (3) possesses, at at least one further (15, 15') of its free outer edges, at least one second fixing pin (16, 16'), extending transversely to the longitudinal axis (11) of the core (10) but substantially perpendicularly to the first fixing pin (14), and that the coil body (7) is arranged so that it can be rotatably shifted on the yoke (3) through approximately 90° about the longitudinal axis (11) of the core (10) to obtain parallel alignment, as desired, of the contact terminal pins (36, 36', 37, 37') and of the coil terminal pins (38, 38') with the first fixing pin or pins (14) or the second fixing pin or pins (16, 16').

2. Relay according to claim 1, characterized in that two parallel fixing pins (14, 16, 16') are disposed at each of the three outer edges (13, 15, 15') of the arm (4) of the yoke (3).

3. Relay according to one of the preceding calibs, characterized in that the fixing pins (14, 16, 16'), the coil terminal pins (38, 38') and contact terminal pins (38, 36', 37, 37') are orientated in parallel rows in the direction of the longitudinal axis (11) of the core (10) facing towards the circuit board (2).

4. Relay according to one of the preceding claims, characterized in that the fixing pins (14, 16, 16'), the coil terminal pins (38, 38') and the contact terminal pins (36, 36', 37, 37') are arranged spaced apart from one another on a grid pattern (R).

5. Relay according to one of the preceding claims, characterized in that a flange (8) of the coil body (7) possesses at least two narrow sides (28, 28', 28'') orientated perpendicularly to one another, the spacings of which from the longitudinal axis (11) of the oore (10) are equal, and one of which is disposed immediately alongside the second arm (5) of the yoke (3) to prevent rotation.

6. Relay according to one of the preceding claims, characterized in that, on one U-part (29) of the coil body (7), two break contacts (33, 33') and two working contacts (31, 31') are disposed, and that two switching contacts (26, 26'), fixed to a contact spring plate (24) of the armature (21), are mounted between the break contacts (33, 33') and the working contacts (31, 31').

7. Relay according to one of the preceding claims, characterized in that the coil terminal pins (38, 38') are fixed between two contact terminal pins (36, 36') by extension ribs (39, 39') in the central region cf the Upart (29) of the coil body (7).

8. Relay according to one of the preceding claims, characterized in that the coil terminal pins (38, 38') are disposed beneath the coil (6) approximately in its longitudinal central zone between the fixing pins (14, 16, 16') of the yoke (3) and the contact terminal pins (36, 36') of the coil body (7).

9. Relay according to one of the preceding claims, oharacterized in that a helical tension spring (19) made from beryllium is disposed outside the rotatably movable coil body (7) under prestress between a lug component (18) of the yoke (3) and a projection (20) of the armature (21).

**Revendications**

1°) Relais électromagnétique comportant une culasse (3) qui présente au moins une branche (4) qui comporte à l'une (13) de ses arêtes extérieures libres au moins un goujon de fixation (14) susceptible d'être introduit dans un trou d'une plaque de circuit imprimé (2) et une bobine d'excitation (6), dont le corps de bobine (7) est fixé sur la branche (4) de la culasse (3) par l'intermédiaire du noyau de bobine (10), en s'appuyant contre une branche (4) par une bride de bobine (9) et ayant au moins un contact fixé (31, 33) avec une tige de raccordement de contact (36, 37) ainsi que des tiges de raccordement de bobine (38) qui s'étendent transversalement par rapport à l'axe longitudinal du noyau de bobine (10) et qui peuvent également s'enficher dans des trous de la plaque de circuit imprimé (2); ainsi qu'un induit (21) articulé sur la culasse (3) chargée par ressort et portant au moins un contact mobile (26), caractérisé en ce que la culasse (3) comporte au moins un second goujon de fixation (16, 16') prévu sur au moins une autre (15, 15') de ses aretes extérieurss libres, ce goujon s'étendant transversalement à l'axe longitudinal (11) du noyau (10), mais toutefois essentiellement à angle droit par rapport au premier goujon de fixation (14), et en ce que le corps de bobine (7) peut être prévu pour l'alignement parallèle, sélectif des tiges de raccordement de contact (36, 36', 37, 37') ainsi que des tiges de raccordement de bobine (38, 38') avec le ou les premiers goujons de fixation (14) ou le ou les seconds goujons de fixation (16, 16'), en étant tourné d'environ 90° autour de l'axe longitudinal (11) du noyau (10) par rapport à la culasse (3).

2°) Relais selon la revendication 1, caractérisé en ce qu'à toutes les arêtes extérieures libres (13, 15, 15') de la branche (4) de la culasse (3), on a chaque fols deux goujons de fixation parallèles (14, 16, 16').

3°) Relais selon l'une des revendications précédentes, caractérisé en ce que les goujons de fixation (14, 16, 16'), les tiges de raccordement de bobine (38, 38') et les tiges de raccordement de contact (36, 36', 37, 37') sont prévus dans des rangées parallèles à la direction de l'axe longitudinal (11) du noyau (10) sur la plaque de circuit imprimé (2).

4°) Relais selon l'une des revendications précédentes, caractérisé en ce que les goujons de fixation (14, 16, 16'), les tiges de raccordement de bobine (38, 38') et les tiges de raccordement de contact (36, 36', 37, 37') sont répartis à distance les uns des autres suivant une subdivision de trame (R).

5°) Relais selon l'une des revendications précédentes, caractérisé en ce qu'une bride (8) du corps de bobine (7) présente au moins deux petits côtés (28, 28', 28'') perpendiculaires entre eux et dont la distance par rapport à l'axe longitudinal (11) du noyau (10) est égale et dont l'une est prévue de façon à assurer la sécurité en rotation, étroitement à côté de la seconde branche (5) de la culasse (3).

6°) Relais selon l'une des revendications précédentes, caractérisé en ce que sur la partie en U (29) du corps de bobine (7), on a deux contacts de repos (33, 33') et deux contacts de travail (31, 31') et en ce qu'entre les contacts de repos (33, 33') et le contact de travail (31, 31'), on a deux contacts de commutation (26, 26') fixés sur une tôle élastique de contact (24) de l'induit (21).

7°) Relais selon l'une des revendications précédentes, caractérisé en ce que les tiges de raccordement de bobine (38, 38') sont fixées par des prolongements de tige (39, 39') dans la zone mediane de la partie en U (29) du corps de bobine (7) entre deux tiges de raccordement de contact (36, 36').

8°) Relais selon l'une des revendications précédentes, caractérisé en ce que les tiges de raccordement de bobine (38, 38') sont prévues sous la bobine (6) sensiblement dans sa zone médiane longitudinale entre les goujons de fixation (14, 16, 16') de la culasse (3) et les tiges de raccordement de contact (36, 36') du corps de bobine (7).

9°) Relais selon l'une des revendications précédentes, caractérisé en ce qu'à l'extérieur du corps de bobine (7) susceptible d'être tourné, on a fixé avec precontrainte un ressort hélicoidal de traction (19) en beryllium, entre une partie de goujon (18) de la culasse (3) et une saillie (20) de l'induit (21).

Fig. 3

Fig. 4

Fig. 5

Fig. 6

3

Fig. 1

Fig. 2